(19) **Europäisches Patentamt / European Patent Office / Office européen des brevets**

(11) **EP 3 872 239 A1**

(12) # EUROPEAN PATENT APPLICATION

(43) Date of publication:
**01.09.2021 Bulletin 2021/35**

(51) Int Cl.:
**C30B 29/36** *(2006.01)*  **C30B 23/00** *(2006.01)*
**H01L 21/02** *(2006.01)*  **H01L 29/16** *(2006.01)*

(21) Application number: **21159276.1**

(22) Date of filing: **25.02.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.02.2020 KR 20200024789**

(71) Applicant: **SKC Co., Ltd.**
**Gyeonggi-do (KR)**

(72) Inventors:
• **PARK, JONG HWI**
 **16205 Suwon-si, Gyeonggi-do (KR)**

• **KO, Sang Ki**
 **16356 Suwon-si, Gyeonggi-do (KR)**
• **KU, KAP-RYEOL**
 **16336 Suwon-si, Gyeonggi-do (KR)**
• **KIM, Jung-Gyu**
 **16327 Suwon-si, Gyeonggi-do (KR)**
• **YANG, Eun Su**
 **16327 Suwon-si, Gyeonggi-do (KR)**
• **LEE, Yeon Sik**
 **16395 Suwon-si, Gyeonggi-do (KR)**

(74) Representative: **BCKIP**
**Siegfriedstraße 8**
**80803 München (DE)**

(54) **WAFER, EPITAXIAL WAFER, METHOD FOR MANUFACTURING A WAFER AND METHOD FOR MANUFACTURING AN EPITAXIAL WAFER**

(57) An epitaxial wafer(20) including a wafer(10) having one surface(11) and an other surface(12), and an epitaxial layer(15) formed on the one surface(11) of the wafer(10), wherein a roughness skewness (Rsk) of the one surface(10) is -3 nm to 3 nm, and a roughness average (Ra) of an edge area(14) of the one surface(11) is different from that of a central area(13) of the one surface(11) by -2 nm to 2 nm when the edge area(14) of the one surface(11) is defined as an area between 13.3% and 32.1% of the radius of the wafer(10) in a direction from the edge of the one surface(11) toward the center thereof and the central area(13) of the one surface(11) is defined as an area at 9.4% of the radius of the wafer(10) from the center of the one surface(11).

**Fig. 1**

<u>10</u>

**EP 3 872 239 A1**

**Description**

BACKGROUND

1. Field

The present disclosure relates to a wafer, an epitaxial wafer, a method for manufacturing a wafer, and a method for manufacturing an epitaxial wafer.

2. Description of the Background

Silicon carbide has high heat resistance and mechanical strength and is physically and chemically stable. Due to these advantages, silicon carbide has received attention as a semiconductor material. Recently, there has been an increasing demand for single-crystal silicon carbide substrates for high-power devices, etc.

Single-crystal silicon carbide is prepared by various processes such as liquid phase epitaxy (LPE), chemical vapor deposition (CVD), and physical vapor transport (PVT). According to physical vapor transport, silicon carbide as a raw material is loaded into a crucible, a seed crystal composed of single-crystal silicon carbide is arranged at the top end of the crucible, the crucible is heated by induction to sublimate the raw material, and as a result, single-crystal silicon carbide is grown on the seed crystal.

Physical vapor transport enables fast growth of single-crystal silicon carbide to produce silicon carbide ingots. Due to this advantage, physical vapor transport is the most widely used process for the production of silicon carbide ingots. However, when a crucible is heated by induction, the current density in the crucible and the internal temperature distribution of the crucible may vary depending on various factors such as characteristics of the crucible, characteristics of a heat insulating material, and process conditions, causing warpage and distortion of a final silicon carbide ingot. Upon subsequent wafer processing, such warpage and distortion may lead to different degrees of processing of the center and edge of the wafer, causing a difference in the roughness of the wafer.

When an epitaxial layer is formed on a wafer manufactured from a silicon carbide ingot, the wafer surface is required to have low asymmetry and uniform roughness, and mechanical damage to the wafer surface needs to be minimized. Non-uniform roughness or lack of low asymmetry of the wafer surface, or mechanical damage to the wafer surface may deteriorate the quality of the epitaxial layer or may pose a risk that the characteristics and yield of a desired semiconductor device may deteriorate.

Thus, configurations of various parameters for the preparation of single-crystal silicon carbide and the manufacture of wafers need to be taken into account to improve the performance and yield of semiconductor devices fabricated from the wafers.

Korean Patent Publication No. 10-2017-0043679 discloses a method for producing a single-crystal silicon carbide substrate for an epitaxial silicon carbide wafer.

The above information is presented as background information only to assist with an understanding of the present disclosure. No determination has been made, and no assertion is made, as to whether any of the above might be applicable as prior art with regard to the disclosure.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, an epitaxial wafer includes a wafer having one surface and an other surface, and an epitaxial layer formed on the one surface of the wafer, wherein a roughness skewness (Rsk) of the one surface is -3 nm to 3 nm, and a roughness average (Ra) of an edge area of the one surface is different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface.

The epitaxial wafer may have a Tu of 5% or less, the Tu being defined by Equation 1:

$$Tu = \frac{(Tmax - Tmin)}{Tavg} \times 100 \qquad (1)$$

where Tu, Tmax, Tmin, and Tavg are the thickness non-uniformity, maximum thickness, minimum thickness, and average thickness of the epitaxial layer, respectively.

The one surface may be a Si plane where a silicon atomic layer is formed.

The Ra of the central area of the one surface may be 4 nm or less.

The Ra of the edge area of the one surface may be 5 nm or less.

The Rsk of the one surface may be -2 nm to 2 nm.

The wafer may be a 4H silicon carbide wafer of 4 inches or more.

In another general aspect, a wafer includes one surface and an other surface, wherein a roughness skewness (Rsk) of the one surface is -3 nm to 3 nm and a roughness average (Ra) of an edge area of the one surface is different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface.

In another general aspect, a method for manufacturing an epitaxial wafer includes arranging a raw material and a silicon carbide seed crystal to face each other in a reactor having an internal space, controlling the internal space to a predetermined temperature, pressure, and atmosphere to sublimate the raw material and grow a silicon carbide ingot from the seed crystal, wherein a heat insulating material surrounds the outer surface of the reactor, heating means controls the temperature of the reactor or the internal space, and the density of the heat insulating material is 0.13 g/cc to 0.28 g/cc, cooling the reactor and recovering the silicon carbide ingot, cutting the recovered silicon carbide ingot into a wafer, planarizing the wafer and polishing the surface of the planarized wafer by bringing a plurality of grinding wheels having different surface particle sizes into contact with the wafer, resulting in the roughness skewness (Rsk) of one surface of the wafer being -3 nm to 3 nm, and the roughness average (Ra) of an edge area of the one surface being different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface, and injecting raw material gases for epitaxial growth into a growth container in which the wafer is arranged, and growing an epitaxial layer on the one surface of the wafer by chemical vapor deposition.

Other features and aspects will be apparent from the following detailed description, the drawings, and the claims.

BRIEF DESCRIPTION OF THE DRAWINGS

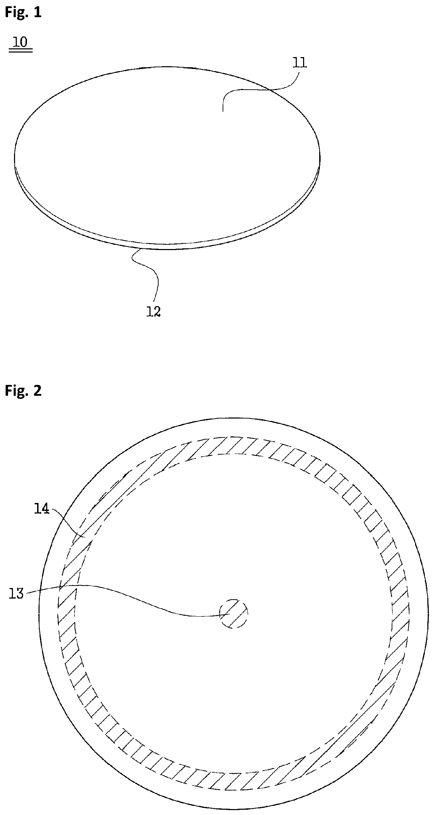

Fig. 1 is a perspective view illustrating an example of a wafer according to one or more example embodiments;

Fig. 2 is a conceptual view illustrating central and edge areas of one surface of a wafer according to one or more example embodiments;

Fig. 3 is a conceptual cross-sectional view illustrating an example of an epitaxial wafer according to one or more example embodiments; and

Fig. 4 is a conceptual view illustrating an example of a system for growing a silicon carbide ingot according to one or more example embodiments.

Throughout the drawings and the detailed description, the same reference numerals refer to the same elements. The drawings may not be to scale, and the relative size, proportions, and depiction of elements in the drawings may be exaggerated for clarity, illustration, and convenience.

DETAILED DESCRIPTION

Hereinafter, while examples of the present disclosure will be described in detail with reference to the accompanying drawings, it is noted that the present disclosure is not limited to the examples presented.

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of this disclosure.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween. As used herein "portion" of an element may include the whole element or less than the whole element.

As used herein, the term "combination of" included in Markush type description means mixture or combination of one or more elements described in Markush type and thereby means that the disclosure includes one or more elements selected from the Markush group.

As used herein, the term "and/or" includes any one and any combination of any two or more of the associated listed items; likewise, "at least one of" includes any one and any combination of any two or more of the associated listed items. For example, the description "A and/or B" means "A or B, or A and B."

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Spatially relative terms, such as "above," "upper," "below," "lower," and the like, may be used herein for ease of description to describe one element's relationship to another element as shown in the figures. Such spatially relative terms are intended to encompass different orientations of the device in use or operation in addition to the orientation depicted in the figures. For example, if the device in the figures is turned over, an element described as being "above," or "upper" relative to another element would then be "below," or "lower" relative to the other element. Thus, the term "above" encompasses both the above and below orientations depending on the spatial orientation of the device. The device may be also be oriented in other ways (rotated 90 degrees or at other orientations), and the spatially relative terms used herein are to be interpreted accordingly.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

Herein, it is noted that use of the term "may" with respect to an example, for example, as to what an example may include or implement, means that at least one example exists in which such a feature is included or implemented while all examples are not limited thereto.

The features of the examples described herein may be combined in various ways as will be apparent after an understanding of this disclosure. Further, although the examples described herein have a variety of configurations, other configurations are possible as will be apparent after an understanding of this disclosure.

The term "wafer" as used herein refers to a so-called bare wafer unless otherwise specifically mentioned.

Herein, Rsk is a measure of the asymmetry of surface heights about the mean line. A positive Rsk means that the height distribution is skewed below the mean line, a negative Rsk value means that the height distribution is skewed above the mean line, and a Rsk of zero (0) indicates symmetry.

One object of example embodiments disclosed herein is to provide a silicon carbide ingot with less warpage and distortion and a method for producing the silicon carbide ingot.

A further object of example embodiments disclosed herein is to provide a wafer with low surface asymmetry and uniform surface roughness and a method for manufacturing the wafer.

Another object of example embodiments disclosed herein is to provide an epitaxial wafer with high thickness uniformity and a method for manufacturing the epitaxial wafer.

Among various factors for low asymmetry and uniform roughness of a silicon carbide wafer manufactured by physical vapor transport, temperature gradients of a crucible and a heat insulating material and wafer polishing conditions are particularly important. In one or more example embodiments control over these conditions enables the manufacture of a wafer of one or more example embodiments having desired characteristics.

Wafer 10

In one aspect, a wafer 10 according to example embodiments includes one surface 11 and an other surface 12 wherein the roughness skewness (Rsk) of the one surface is -3 nm to 3 nm and the roughness average (Ra) of an edge area 14 of the one surface is different from that of a central area 13 of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface.

The one surface 11 of the wafer is a so-called Si plane where silicon atoms are mainly found on the surface and the other surface 12 opposite to the one surface is a so-called C plane where carbon atoms are mainly found on the surface. When the wafer is processed by cutting, the single-crystal silicon carbide tends to be cut at the interface between the carbon atomic layer and the silicon atomic layer or in the direction parallel to the interface, with the result that a plane where carbon atoms are mainly exposed and a plane where silicon atoms are mainly exposed appear on the respective cut surfaces.

The wafer 10 may have a circular or elliptical shape in cross sectional. In this case, the center of the one surface 11 may correspond to the center of the circle or ellipse and the radius of the one surface 11 may correspond to the shortest radius of the circle or ellipse.

The Ra of the central area 13 of the one surface 11 may be 4 nm or less, 3.84 nm or less, 3 nm or less, 2.54 nm or less, 2 nm or less, 1 nm or less, 0.1 nm or less, 0.073 nm or less, or 0.068 nm or less.

The Ra of the central area 13 of the one surface 11 may be 0.01 nm or more or 0.063 nm or more.

The Ra of the edge area 14 of the one surface 11 may be 5 nm or less, 4 nm or less, 3.64 nm or less, 2 nm or less, 0.94 nm or less, 0.54 nm or less, 0.24 nm or less, or 0.068 nm or less.

The Ra of the edge area 14 of the one surface 11 may be 0.01 nm or more or 0.061 nm or more.

The Ra of the edge area 14 of the one surface 11 may be different from that of the central area 13 of the one surface by -2 nm to 2 nm, -1.35 nm to 1.35 nm, -1.165 nm or 1.165 nm, -0.87 nm to 0.87 nm, or -0.007 nm to 0.007 nm.

When the difference in Ra between the central area 13 and the edge area 14 of the one surface 11 is in the range defined above, the non-uniformity between the center and edge of the one surface can be minimized, the quality of an epitaxial layer to be formed by subsequent epitaxial growth can be improved, and a device can be fabricated in high yield.

The overall Ra of the one surface 11 may be less than 0.3 nm or less than 0.2 nm. The overall Ra of the one surface 11 may be 0.01 nm or more.

When the overall Ra is in the range defined above, the quality of an epitaxial layer to be formed by subsequent epitaxial growth can be improved and a device can be fabricated in high yield.

The Rsk of the one surface 11 may be -3 nm to 3 nm, -2 nm to 2 nm, -1.0 nm to 1.0 nm, - 0.63 nm to 0.63 nm, or -0.037 nm to 0.037 nm.

Rsk is a measure of the asymmetry of surface heights about the mean line. The Rsk value of the wafer may affect the thickness uniformity of an epitaxial layer to be formed in a subsequent process.

When the Rsk of the one surface 11 is in the range defined above, the asymmetry of the one surface can be minimized, the thickness uniformity and flatness of an epitaxial layer to be formed in a subsequent process can be enhanced, and the number of defects, including downfall defects, triangular defects, and carrot defects that may deteriorate the characteristics of a device can be reduced.

A low overall Ra can lead to an improvement in the quality of the epitaxial layer. However, the inventors have found empirically that the difference in Ra between central and edge areas of a wafer sample may cause a difference in the quality of an epitaxial layer formed on the wafer sample despite a lower Ra of the wafer sample and that the average Rsk also possibly affects the quality of the epitaxial layer.

When the overall Ra of the one surface 11 is less than 0.3 nm and the Ra of the edge area 14 of the one surface 11 is different from that of the central area 13 of the one surface by -1.165 nm to 1.165 nm, the quality of the epitaxial layer can be further improved.

When the overall Ra of the one surface 11 is less than 0.3 nm and the Rsk of the one surface 11 is -1.0 nm to 1.0 nm, the quality of the epitaxial layer can be further improved.

When the Ra of the edge area 14 of the one surface 11 is different from that of the central area 13 of the one surface by -1.35 nm to 1.35 nm and the overall Ra of the one surface 11 is 0.2 nm or less, the quality of the epitaxial layer can be further improved.

When the Ra of the edge area 14 of the one surface 11 is different from that of the central area 13 of the one surface by -1.0 nm to 1.0 nm and the overall Ra of the one surface 11 is 2.5 nm or less, the quality of the epitaxial layer can be further improved.

When the Ra of the edge area 14 of the one surface 11 is different from that of the central area 13 of the one surface by -0.3 nm to 0.3 nm and the overall Ra of the one surface 11 is 1.4 nm or less, the quality of the epitaxial layer can be further improved.

The Ra and Rsk of the wafer 10 can be measured by the procedure described in the following experimental examples.

The wafer 10 may have a rocking angle of -1.5° to 1.5°, -1.0° to 1.0°, -0.5° to 0.5°, or -0.3° to 0.3° with respect to a reference angle. Within this range, high crystal quality of the wafer is ensured. That is, the crystallinity of the wafer can be evaluated by the rocking angle. The rocking angle can be determined by the following procedure. First, the [11-20] direction of the wafer is adjusted to the X-ray path using a high-resolution X-ray diffraction system (HR-XRD system). The X-ray source optic and X-ray detector optic angles are set to 2θ (35° to 36°). Thereafter, a rocking curve is measured by controlling the omega (ω) or theta (θ) (X-ray detector optic) angle depending on the off angle of the wafer. The peak angle is defined as a reference angle. The differences between the reference angle and two full width at half maximum (FWHM) values are set to the rocking angle range.

As used herein, the expression "off angle of X°" means that the off angle is X° with a generally allowable error range. For example, the off angle is in the range of (X°-0.05°) to (X°+0.05°). As used herein, the expression "rocking angle of -1° to 1° with respect to a reference angle" means that the full width at half maximum (FWHM) values are in the range of -1° to +1° with respect to the peak angle as a reference angle (that is, (peak angle -1°) to (peak angle +1°)). The rocking angle is determined by dividing the surface of the wafer, except for the central portion of the wafer and the portion 5 mm distant from the edge in the direction toward the center, into three substantially equal portions, measuring rocking angles at least three times in each of the portions, and averaging the measured results. Specifically, when the wafer is cut at an off angle of 0° to 10° with respect to the (0001) plane of the silicon carbide ingot, the omega angle is 17.8111° for an off angle of 0°, 13.811° for an off angle of 4°, and 9.8111° for an off angle of 8°.

The thickness of the wafer 10 may be 150 μm (microns) to 900 μm or 200 μm to 600 μm, which is suitably applicable to semiconductor devices, but is not limited thereto.

The wafer 10 may be composed substantially of 4H single-crystal silicon carbide in which a minimal number of defects or polymorphs are incorporated.

The wafer 10 may have a diameter of 4 inches or more, 5 inches or more or 6 inches or more. The diameter of the wafer may be 12 inches or less, 10 inches or less or 8 inches or less.

The wafer 10 can be manufactured by a method described below.

Epitaxial Wafer 20

In a further aspect, an epitaxial wafer 20 according to example embodiments includes the wafer 10 and an epitaxial layer 15 formed on one surface of the wafer 10.

The epitaxial layer may have a Tu of 5% or less, the Tu being defined by Equation 1:

$$Tu = \frac{(Tmax - Tmin)}{Tavg} \times 100 \qquad (1)$$

where Tu, Tmax, Tmin, and Tavg are the thickness non-uniformity, maximum thickness, minimum thickness, and average thickness of the epitaxial layer, respectively.

The average thickness, Tavg, of the epitaxial layer may be the average of the maximum and minimum thicknesses of the epitaxial layer.

The Tu represents the thickness non-uniformity of the epitaxial layer 15 and may be 5% or less, 4.5% or less, or 4% or less. The Tu may be 2% or less or 1.5% or less and 0% or more.

The Tu value may be affected by the difference in Ra between the edge 14 and the central area 13 of the one surface 11 of the wafer 10 and the Rsk value of the one surface of the wafer. In example embodiments, the Tu may be reduced to or below the predetermined value by controlling the roughness difference and the Rsk to respective specific ranges.

When the Tu value is in the range defined above, the epitaxial wafer 20 has good quality and uniform thickness and can be used to fabricate a device with improved characteristics and yield.

The thickness of the epitaxial layer 15 may be 8 μm to 20 μm but is not necessarily limited thereto.

The epitaxial layer 15 may include n- or p-type dopant atoms at a concentration of $1 \times 10^{14}/cm^3$ to $1 \times 10^{19}/cm^3$.

The epitaxial layer 15 may include silicon carbide.

The epitaxial layer 15 may be composed substantially of silicon carbide.

The epitaxial wafer 20 may further include a second epitaxial layer (not illustrated) formed on the epitaxial layer 15.

The second epitaxial layer may have the same features as the epitaxial layer 15 in terms of thickness, dopant atom content, and composition (components).

The second epitaxial layer may be identical to the epitaxial layer 15.

The epitaxial wafer 20 can be applied to Schottky barrier diodes, PIN diodes, metal semiconductor field transistors, etc. and can also be applied to other semiconductor devices.

The epitaxial wafer 20 can be manufactured by a method for manufacturing an epitaxial wafer, which is described below.

Method for Manufacturing Wafer

In another aspect, a method for manufacturing a wafer according to example embodiments may include the steps of: arranging a raw material 300 and a silicon carbide seed crystal to face each other in a reactor 200 having an internal space (preparation step); controlling the temperature, pressure, and atmosphere of the internal space to sublimate the raw material and grow a silicon carbide ingot 100 from the seed crystal (growth step); cooling the reactor and recovering the silicon carbide ingot (cooling step); cutting the recovered silicon carbide ingot into a wafer (cutting step); and planarizing the wafer and polishing the surface of the planarized wafer (processing step), wherein a heat insulating material surrounds the outer surface of the reactor, a heater, for example, a heating coil such as an inductive coil, a radiative heater, a resistance heater, etc., controls the temperature of the reactor or the internal space, the density of the heat insulating material may be 0.13 g/cc to 0.28 g/cc, and the raw material 300 and the silicon carbide seed crystal are arranged to face each other in the reactor 200 having the internal space in the preparation step.

The size of the silicon carbide seed crystal may vary depending on the size of a desired wafer and C-plane (000-1) of the silicon carbide seed crystal may be directed toward the raw material 300.

The raw material 300 may be in the form of a powder including a carbon source and a silicon source. The raw material may be a necked or surface carbonized silicon carbide powder.

The reactor 200 may be a container where a reaction for the growth of the silicon carbide ingot occurs. The reactor 200 may be specifically a graphite crucible but is not limited thereto. For example, the reactor 200 may include: a body 210 having an internal space and an opening; and a cover 220 corresponding to the opening and closing the internal space. The cover of the crucible may further include a seed crystal holder integrated with or separated from the cover. The silicon carbide seed crystal can be fixed by the seed crystal holder to face the raw material.

The reactor 200 is surrounded and fixed by a heat insulating material 400. The heat insulating material 400 surrounding the reactor is located in a reaction chamber 500 such as a quartz tube. The internal temperature of the reactor 200 can be controlled by the heater 600 provided outside the heat insulating material and the reaction chamber.

The heat insulating material 400 may have a porosity in the range of 72% to 95%, 75% to 93% or 80% to 91%. The use of the heat insulating material 400 whose porosity is in the range defined above can reduce the formation of cracks in the grown silicon carbide ingot.

The heat insulating material 400 may have a compressive strength of 0.2 MPa or more, 0.48 MPa or more or 0.8 MPa or more. The compressive strength of the heat insulating material may be 3 MPa or less or 2.5 MPa or less. When the compressive strength of the heat insulating material is in the range defined above, good thermal/mechanical stability of the silicon carbide ingot is ensured and the probability of ash occurrence is lowered, achieving high quality of the silicon carbide ingot.

The heat insulating material 400 may include a carbonaceous felt, specifically a graphite felt. The carbonaceous felt may be a rayon- or pitch-based graphite felt.

The heat insulating material 400 may have a density of 0.13 g/cc or more, 0.138 g/cc or more, 0.168 g/cc or more, or 0.17 g/cc or more. The density of the heat insulating material may be 0.28 g/cc or less, 0.24 g/cc or less, 0.20 g/cc or less, or 0.18 g/cc or less. Within this range, the occurrence of warpage and distortion of the ingot can be suppressed and low Ra and Rsk values of a wafer manufactured from the ingot can be ensured.

A vacuum exhauster 700 is in communication with the reaction chamber 500 to control the degree of vacuum in the reaction chamber. A line 810, through which a gas is injected into the reaction chamber, is also in communication with the reaction chamber. A mass flow controller 800 is provided in the line to control the gas injection. By these elements, the flow rates of an inert gas can be controlled in the subsequent growth and cooling steps.

In the growth step, the temperature, pressure, and atmosphere of the internal space are controlled to sublimate the raw material and grow a silicon carbide ingot from the seed crystal.

The growth step can be carried out by heating the reactor 200 and the internal space of the reactor with the heater 600. Simultaneously with or separately from the heating, the internal space may be depressurized to control the degree of vacuum and an inert gas may be injected to induce the growth of the silicon carbide ingot.

The growth step can be carried out at a temperature of 2000 °C to 2600 °C and a pressure of 1 torr to 200 torr. Under these conditions, the silicon carbide ingot can be produced in a more efficient manner.

Specifically, the growth step can be carried out in the reactor 200 where the upper and lower surface temperatures are 2100 °C to 2500 °C and the pressure of the internal space is 1 torr to 50 torr. More specifically, the growth step can be carried out in the reactor where the upper and lower surface temperatures are 2150 °C to 2450 °C and the pressure of the internal space is 1 torr to 40 torr. Even more specifically, the growth step can be carried out in the reactor where the upper and lower surface temperatures are 2150 °C to 2350 °C and the pressure of the internal space is 1 torr to 30 torr.

Under these conditions for the growth step, higher quality of the silicon carbide ingot can be ensured.

The growth step can be carried out by heating the internal space to the temperature range defined above at a rate of 1 °C/min to 10 °C/min or 5 °C/min to 10 °C/min.

In the growth step, a predetermined amount of an inert gas may be supplied to the exterior of the reactor 200. A flow of the inert gas may be created in the internal space of the reactor 200. The inert gas may flow from the raw material 300 in the direction towards the silicon carbide seed crystal. Thus, a stable temperature gradient may be established in the reactor and the internal space.

The inert gas may be specifically argon, helium or a mixture thereof.

In the cooling step, the silicon carbide ingot grown in the growth step is cooled at a predetermined rate under a flow of an inert gas.

The cooling step can be carried out at a rate of 1 °C/min to 10 °C/min or 1 °C/min to 5 °C/min.

In the cooling step, the pressure of the internal space of the reactor 200 may be controlled simultaneously when the silicon carbide ingot is cooled. Alternatively, the pressure control may be executed separately from the cooling of the silicon carbide ingot. The pressure of the internal space can be controlled to a maximum of 760 torr.

A predetermined amount of an inert gas may be supplied to the reactor 200 in the cooling step, as in the growth step. A flow of the inert gas may be created in the internal space of the reactor. The inert gas may flow from the raw material 300 in the direction towards the silicon carbide seed crystal.

In the silicon carbide ingot 100 recovered after the cooling step, the height of the growth end may be different from that of the edge by -1 mm or more, 0.1 mm or more, or 1 mm or more. The growth end refers to the highest point when the growth plane is directed upwards. The height difference may be 12 mm or less, 10 mm or less, or 9 mm or less. The height difference can be calculated by measuring the maximum height of a portion protruding from the growth end and the maximum height of the edge of the silicon carbide ingot, as viewed from the front of the recovered silicon carbide ingot, using a height gauge.

If the value obtained by subtracting the height of the edge of the silicon carbide ingot from the height of the growth end thereof is less than -1 mm, polymorphs are formed to deteriorate the quality of the ingot. Meanwhile, if the value exceeds 12 mm, there is a high possibility that the yield of the ingot may deteriorate or cracks are likely to occur in the ingot.

In example embodiments, the value obtained by subtracting the height of the edge of an ingot from the height of the growth end thereof may be used as a criterion for evaluating the quality of the ingot, and as a result, wafer samples or epitaxial wafer samples having substantially the same value obtained by subtracting the height of the edge of an ingot from the height of the growth end thereof may be different in quality.

In example embodiments, when the value obtained by subtracting the height of the edge (periphery) of the silicon carbide ingot from the height (center) of the growth end thereof is low or approaches zero (0), it has an influence on the quality of wafer samples or epitaxial wafer samples.

In example embodiments, when the Ra of the edge area of one surface of the wafer, the difference in Ra between the edge and central areas of the one surface, and the Rsk of the edge area of the one surface fall in the respective ranges defined in the example embodiments as described herein, the quality of the wafer can be further improved.

In the cutting step, the silicon carbide ingot recovered in the cooling step is cut into a wafer.

The silicon carbide ingot may be cut at an off angle with respect to the (0001) plane of the silicon carbide ingot or a plane where the silicon carbide ingot begins to grow. The off angle may be 0° to 10°.

The cutting step can be carried out such that the thickness of the wafer is 150 $\mu$m to 900 $\mu$m or 200 $\mu$m to 600 $\mu$m. However, the thickness of the wafer is not limited.

In the processing step, the wafer is planarized and the surface of the planarized wafer is polished. For the wafer planarization, wheel grinding can be sequentially applied to both sides of the wafer. This process is called lapping. A diamond abrasive may be used for the wheel grinding. In this case, the diamond abrasive has a surface particle size of 500 mesh to 10000 mesh.

The planarization in the processing step reduces damage or stress to the wafer caused in the cutting step and makes the wafer flat.

The polishing of the surface of the planarized wafer in the processing step may further include wet etching.

In the processing step, the surface of the planarized wafer can be polished by bringing a plurality of grinding wheels having different surface particle sizes into contact with one surface of the wafer. The other surface of the wafer can also be polished with the grinding wheels. The other surface can be polished in the same manner as the one surface.

Specifically, the surface polishing in the processing step may include the substeps of processing with a first grinding wheel having a surface particle size of 1000 mesh to 3000 mesh (first processing substep) and processing with a second grinding wheel having a surface particle size of 6000 mesh to 10000 mesh (second processing substep).

Particles may be embedded in the surface of the grinding wheels and their size is expressed as mesh. The mesh is indicative of the number of openings per inch. The particles may be diamond particles.

Each of the grinding wheels and the wafer may rotate in opposite directions for the surface polishing in the processing step. Each of the grinding wheels may have a diameter larger than that of the wafer. The diameter of each of the grinding wheels may be not larger than 250 mm.

The surface polishing in the processing step may further include the substep of chemical mechanical polishing.

The chemical mechanical polishing can be performed by bringing the wafer fixed to a rotating polishing head into contact with a slurry of abrasive particles under a predetermined pressure while supplying the slurry onto a rotating platen.

The method may further include the step of cleaning with a standard RCA chemical cleaning solution after the processing step.

Method for Manufacturing Epitaxial Wafer

In yet another aspect, a method for manufacturing an epitaxial wafer according to example embodiments may include the steps of: injecting raw material gases for epitaxial growth into a growth container in which the wafer 10 is arranged, and growing an epitaxial layer on one surface 11 of the wafer by chemical vapor deposition (growth step).

The growth step may further include the substep of etching the surface of the wafer 10 with a gas before injection of the raw material gases. The gas etching can be performed by the addition of a predetermined amount of hydrogen gas while maintaining the wafer at a temperature of 1400 °C to 1600 °C.

In the growth step, the wafer is first arranged in a growth container, the growth container is evacuated to a vacuum, and a carbonaceous gas and a silicon-based gas as the raw material gases are injected into the growth container. A doping gas such as nitrogen gas may be further injected into the growth container. The carbonaceous gas and the silicon-based gas are injected in such amounts that the concentration ratio of carbon atoms to silicon atoms is 0.5:1 to 2:1.

The carbonaceous gas can be selected from $CH_4$, $C_2H_4$, $C_2H_6$, $C_3H_6$, $C_3H_8$, and mixtures thereof and the silicon-based gas can be selected from $SiH_4$, $SiCl_4$, $SiHCl_3$, $SiH_2Cl_2$, $SiH_3Cl$, $Si_2H_6$, and mixtures thereof.

In the growth step, an epitaxial layer grows on the one surface 11 of the wafer 10 while maintaining a temperature of 1400 °C to 1700 °C after injection of the gases.

The grown epitaxial layer 15 of the epitaxial wafer 20 may be 5 $\mu$m to 20 $\mu$m in thickness.

After the growth step, the injection of the raw material gases is stopped, the growth container is cooled to room temperature and evacuated, the growth container is pressurized to atmospheric pressure with an inert gas, and the epitaxial wafer 20 is recovered.

The growth step may be repeated twice or more, if needed. In this case, a second epitaxial layer (not illustrated) may be formed on the epitaxial layer 15. The additional growth step for the formation of the second epitaxial layer can may be carried out in the same manner as the growth step for the formation of the epitaxial layer 15. Alternatively, the temperature, the composition of the raw material gases, and the type of the doping gas in the additional growth step may be different from those in the growth step for the formation of the epitaxial layer 15.

The features of the epitaxial wafer 20 are the same as those described above.

Example embodiments will be explained in more detail with reference to the following examples. However, these examples are merely illustrative to assist in understanding example embodiments and are not intended to limit the scope of example embodiments.

Production of Silicon Carbide Ingots

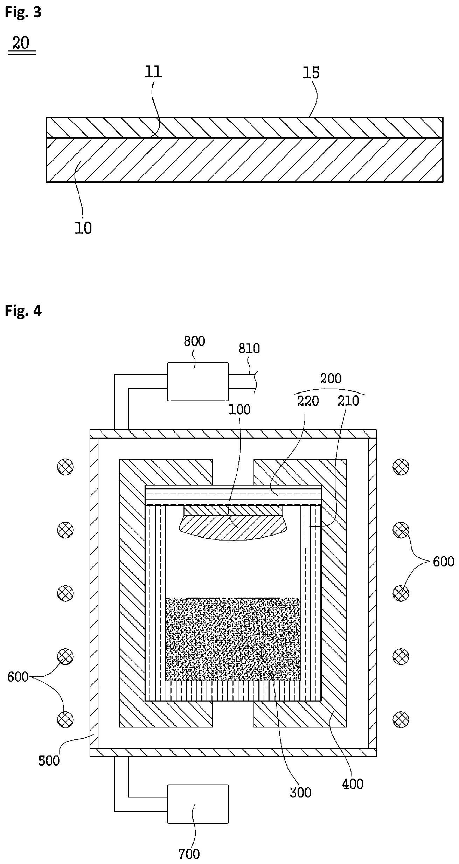

The system illustrated in Fig. 4 was used to produce silicon carbide ingots. First, a silicon carbide powder as a raw material was loaded into the lower portion of the internal space of the reactor 200 and a silicon carbide seed crystal was arranged in the upper portion of the internal space. Here, the silicon carbide seed crystal was composed of a 4H silicon carbide crystal having a diameter of 6 inches and was fixed such that its C plane (000-1) was directed towards the silicon carbide raw material arranged in the lower portion of the internal space.

The reactor 200 was sealed, surrounded by the heat insulating material 400, and arranged in a quartz tube 500 provided with a heating coil as an external heater 600. The density of the heat insulating material 400 is shown in Table 1. The internal space of the reactor was evacuated to a vacuum, argon gas was introduced into the internal space until the internal space reached 760 torr, and the internal space was depressurized. Simultaneously with the depressurization, the internal space was heated at a rate of 5 °C/min to 2300 °C. The amount of argon gas flowing in the quartz tube was controlled through the line 810 in communication with the quartz tube using the vacuum exhauster 700. A silicon carbide ingot was grown on the silicon carbide seed crystal facing the silicon carbide raw material at a temperature of 2300 °C and a pressure of 20 torr for 100 h.

After growth, the temperature of the internal space was reduced to 25 °C at a rate of 5 °C/min and simultaneously the pressure of the internal space was adjusted to 760 torr. The amount of argon gas flowing in the quartz tube was controlled through the line 810 in communication with the quartz tube using the vacuum exhauster 700.

Manufacture of Wafers

The cooled silicon carbide ingot was cut at an off angle of 4° relative to its (0001) plane to manufacture a wafer having a thickness of 360 $\mu$m.

The wafer was planarized, followed by chemical mechanical polishing (CMP). The wafer sample was fixed to a polishing head of a CMP system and one surface of the wafer was directed towards a polyurethane polishing pad attached to a platen. Then, the one surface of the wafer was polished at a pressure of 5 psi with the addition of a manganese slurry while rotating the platen at 200 rpm and the polishing head at 197 rpm. The polished wafer was cleaned and dried.

Measurement of Roughness of Wafer Samples

A wafer sample of 10×10 mm$^2$ was obtained by cutting an edge area between 13.3% to 32.1% (10 mm to 24 mm) of the radius of the wafer in a direction from the edge of the one surface (Si plane) toward the center thereof. A wafer sample of 10×10 mm$^2$ was obtained by cutting a central area at 9.4% (7.05 mm) of the radius of the wafer from the center of the one surface. The Ra values at five randomly selected points (5×5 $\mu$m$^2$) of each wafer sample and the overall Ra and Rsk values of the wafer were measured using an atomic force microscope (AFM) (model XE-150, available from PARK SYSTEMS). The results are shown in Table 1.

TABLE 1

|  | Density of heat insulating material (g/cc) | Ra of the central area (nm) | Ra of the edge area (nm) | Difference in Ra between central and edge areas (nm) | Overall Ra (nm) | Overall Rsk (nm) |
|---|---|---|---|---|---|---|
| Example 1 | 0.177 | 0.07 | 0.932 | 0.862 | 0.242 | -0.043 |
| Example 2 | 0.177 | 0.072 | 0.536 | 0.464 | 0.165 | 0.01 |
| Example 3 | 0.177 | 0.072 | 0.434 | 0.362 | 0.144 | 0.037 |
| Example 4 | 0.17 | 0.067 | 0.068 | 0.001 | 0.067 | 1.037 |
| Example 5 | 0.17 | 0.068 | 0.061 | -0.007 | 0.067 | -0.103 |
| Example 6 | 0.17 | 0.066 | 0.064 | -0.002 | 0.066 | 0.024 |
| Example 7 | 0.168 | 2.538 | 3.114 | 0.576 | 2.653 | -0.041 |
| Example 8 | 0.168 | 2.295 | 3.637 | 1.342 | 2.563 | -0.035 |
| Example 9 | 0.138 | 3.831 | 5 | 1.169 | 4.065 | 0.14 |

Referring to Table 1, the absolute values of the differences in Ra between the central and edge areas of the wafer samples of Examples 1-9, which were manufactured using the heat insulating material having a density in the range of 0.13-0.28 g/cc, were not greater than 2 nm, the absolute Rsk values were not greater than 3 nm, and the overall Ra values of some of the wafer samples were less than 0.3 nm, demonstrating low asymmetry, small differences in Ra, and low overall Ra values of the wafers.

Manufacture of Epitaxial Wafers

Each of the wafers was arranged in a growth container. $SiH_4$ and $C_3H_8$ gases as raw material gases for epitaxial growth and nitrogen as a doping gas were injected into the growth container to grow an epitaxial layer on one surface of the wafer by chemical vapor deposition. The thickness of the epitaxial layer was 12 $\mu$m and the dopant concentration was $8 \times 10^{15}/cm^3$.

After growth, the injection of the raw material gases was stopped, the growth container was cooled to room temperature and evacuated, the growth container was pressurized to atmospheric pressure with an inert gas, and the epitaxial wafer was recovered.

Measurement of Thickness Non-uniformities of the Epitaxial Layers of the Epitaxial Wafers

The maximum and minimum thicknesses of each of the recovered epitaxial wafers were measured and the non-uniformity of the epitaxial wafer was calculated by Equation 1:

$$Tu = \frac{(Tmax - Tmin)}{Tavg} \times 100 \qquad (1)$$

where Tu, Tmax, Tmin, and Tavg are the thickness non-uniformity, maximum thickness, minimum thickness, and average thickness of the epitaxial layer, respectively.

The results are shown in Table 2.

TABLE 2

|  | Density of heat insulating material (g/cc) | Tu (%) |
| --- | --- | --- |
| Example 1 | 0.177 | 0.57 |
| Example 2 | 0.177 | 1.26 |
| Example 3 | 0.177 | 0.98 |
| Example 4 | 0.17 | 2.03 |
| Example 5 | 0.17 | 1.67 |
| Example 6 | 0.17 | 1.54 |
| Example 7 | 0.168 | 1.82 |
| Example 8 | 0.168 | 1.65 |
| Example 9 | 0.138 | 4.42 |

Referring to Tables 1 and 2, the epitaxial layer of each of the epitaxial wafers, which was manufactured by forming the epitaxial layer on one surface of the corresponding wafer and in which the absolute value of the difference in Ra between the central and edge areas of the one surface was not greater than 2 nm and the absolute Rsk value was not greater than 3 nm, had a thickness non-uniformity not greater than 5%, demonstrating high quality of the epitaxial wafer.

The wafer of example embodiments described herein has a small difference in roughness between the edge and central areas of the one surface and is less asymmetric.

The epitaxial wafer of example embodiments described herein has a more uniform thickness and can be used to fabricate a semiconductor device with improved characteristics and yield.

While specific examples have been shown and described above, it will be apparent after an understanding of this disclosure that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

**Claims**

1. An epitaxial wafer comprising:

   a wafer comprising one surface and an other surface; and
   an epitaxial layer formed on the one surface of the wafer,
   wherein a roughness skewness (Rsk) of the one surface is -3 nm to 3 nm, and a roughness average (Ra) of an edge area of the one surface is different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface.

2. The epitaxial wafer according to claim 1, wherein the epitaxial wafer has a Tu of 5% or less, the Tu being defined by Equation 1:

$$Tu = \frac{(Tmax - Tmin)}{Tavg} \times 100 \qquad (1)$$

   where Tu, Tmax, Tmin, and Tavg are the thickness non-uniformity, maximum thickness, minimum thickness, and average thickness of the epitaxial layer, respectively.

3. The epitaxial wafer according to claim 1 or claim 2, wherein the one surface is a Si plane where a silicon atomic layer is formed.

4. The epitaxial wafer according to any one of claim 1 to claim 3, wherein the Ra of the central area of the one surface is 4 nm or less.

5. The epitaxial wafer according to any one of claim 1 to claim 4, wherein the Ra of the edge area of the one surface is 5 nm or less.

6. The epitaxial wafer according to any one of claim 1 to claim 5, wherein the Rsk of the one surface is -2 nm to 2 nm.

7. The epitaxial wafer according to any one of claim 1 to claim 6, wherein the wafer is a 4H silicon carbide wafer of 4 inches or more.

8. A wafer comprising:

   one surface and an other surface,
   wherein a roughness skewness (Rsk) of the one surface is -3 nm to 3 nm and a roughness average (Ra) of an edge area of the one surface is different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface.

9. The wafer according to claim 8, wherein the one surface is a Si plane where a silicon atomic layer is formed.

10. The wafer according to claim 8 or claim 9, wherein the Ra of the central area of the one surface is 4 nm or less and the Ra of the edge area of the one surface is 5 nm or less.

11. The wafer according to any one of claim 8 to claim 10, wherein the Rsk of the one surface is -2 nm to 2 nm.

12. A method for manufacturing an epitaxial wafer, comprising:

   arranging a raw material and a silicon carbide seed crystal to face each other in a reactor having an internal space; controlling the internal space to a predetermined temperature, pressure, and atmosphere to sublimate the raw material and grow a silicon carbide ingot from the seed crystal, wherein a heat insulating material surrounds the outer surface of the reactor, a heater controls the temperature of the reactor or the internal space, and the density of the heat insulating material is 0.13 g/cc to 0.28 g/cc;

cooling the reactor and recovering the silicon carbide ingot;

cutting the recovered silicon carbide ingot into a wafer;

planarizing the wafer and polishing the surface of the planarized wafer comprising bringing a plurality of grinding wheels having different surface particle sizes into contact with the wafer, resulting in the roughness skewness (Rsk) of one surface of the wafer being -3 nm to 3 nm, and the roughness average (Ra) of an edge area of the one surface being different from that of a central area of the one surface by -2 nm to 2 nm when the edge area of the one surface is defined as an area between 13.3% and 32.1% of the radius of the wafer in a direction from the edge of the one surface toward the center thereof and the central area of the one surface is defined as an area at 9.4% of the radius of the wafer from the center of the one surface; and

injecting raw material gases for epitaxial growth into a growth container in which the wafer is arranged, and growing an epitaxial layer on the one surface of the wafer by chemical vapor deposition.

13. The method according to claim 12, wherein the epitaxial wafer has a Tu of 5% or less, the Tu being defined by Equation 1:

$$Tu = \frac{(Tmax - Tmin)}{Tavg} \times 100 \qquad (1)$$

where Tu, Tmax, Tmin, and Tavg are the thickness non-uniformity, maximum thickness, minimum thickness, and average thickness of the epitaxial layer, respectively.

**Fig. 1**

10

11

12

**Fig. 2**

14

13

**Fig. 3**

20

**Fig. 4**

Europäisches
Patentamt

European
Patent Office

Office européen
des brevets

# EUROPEAN SEARCH REPORT

**Application Number**

EP 21 15 9276

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 752 508 A1 (NIPPON STEEL & SUMITOMO METAL CORP [JP]) 9 July 2014 (2014-07-09) * claims 1-8; figures 2-4; examples a1-a5 * | 1-13 | INV. C30B29/36 C30B23/00 H01L21/02 H01L29/16 |
| A | WO 2018/211842 A1 (SUMITOMO ELECTRIC INDUSTRIES [JP]) 22 November 2018 (2018-11-22) * abstract; figures 1-14 * | 1-13 | |

-----

-----

**TECHNICAL FIELDS SEARCHED (IPC)**

C30B
H01L

The present search report has been drawn up for all claims

| Place of search | Date of completion of the search | Examiner |
|---|---|---|
| The Hague | 17 July 2021 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 21 15 9276

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2021

| Patent document cited in search report | | Publication date | Patent family member(s) | | Publication date |
|---|---|---|---|---|---|
| EP 2752508 | A1 | 09-07-2014 | CN | 103620095 A | 05-03-2014 |
| | | | EP | 2752508 A1 | 09-07-2014 |
| | | | JP | 5506954 B2 | 28-05-2014 |
| | | | JP | 5682643 B2 | 11-03-2015 |
| | | | JP | 6109028 B2 | 05-04-2017 |
| | | | JP | 2014028736 A | 13-02-2014 |
| | | | JP | 2014028757 A | 13-02-2014 |
| | | | JP | WO2013031856 A1 | 23-03-2015 |
| | | | KR | 20130137247 A | 16-12-2013 |
| | | | US | 2014363607 A1 | 11-12-2014 |
| | | | WO | 2013031856 A1 | 07-03-2013 |
| WO 2018211842 | A1 | 22-11-2018 | CN | 110651072 A | 03-01-2020 |
| | | | JP | WO2018211842 A1 | 26-03-2020 |
| | | | US | 2020083039 A1 | 12-03-2020 |
| | | | WO | 2018211842 A1 | 22-11-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020170043679